# EUROPÄISCHE PATENTSCHRIFT

(11) **EP 1 604 262 B1**
(45) Veröffentlichungstag und Bekanntmachung des Hinweises auf die Patenterteilung: **23.07.2008**
(21) Anmeldenummer: 04708724.2
(22) Anmeldetag: 06.02.2004
(51) Int. Cl.: G06F 1/20

(54) **FLÜSSIGKEITS-KÜHLSYSTEM**
LIQUID COOLING SYSTEM
SYSTEME DE REFROIDISSEMENT A FLUIDE

(30) Priorität: 07.03.2003 DE 10310282
(43) Veröffentlichungstag der Anmeldung: 14.12.2005
(73) Patentinhaber: Rittal GmbH & Co. KG, 35745 Herborn (DE)
(72) Erfinder: NICOLAI, Michael, 35466 Rabenau (DE); DÖRRICH, Martin, 35764 Sinn (DE); STRACKBEIN, Heinrich, 35444 Biebertal (DE); HAIN, Markus, 35684 Dillenburg (DE); KREILING, Jörg, 35444 Biebertal (DE)
(74) Vertreter: Fleck, Hermann-Josef
(86) Internationale Anmeldenummer: PCT/EP2004/001084
(87) Internationale Veröffentlichungsnummer: WO 2004/080132

(56) Entgegenhaltungen:
- DE-A- 10 112 389
- US-A- 5 424 916
- US-A- 5 509 468
- PATENT ABSTRACTS OF JAPAN Bd. 2003, Nr. 04, 2. April 2003 (2003-04-02) & JP 2002 374086 A (HITACHI LTD; HITACHI INFORMATION TECHNOLOGY CO LTD), 26. Dezember 2002 (2002-12-26)

## Beschreibung

Die Erfindung bezieht sich auf ein Flüssigkeits-Kühlsystem mit mehreren in einem Rack oder Schaltschrank untergebrachten und jeweiligen zu kühlenden Elektronikbaugruppen individuell zugeordneten Kühleinheiten und ferner mit einer Überwachungs- und Steuerungseinrichtung zum Überwachen der Kühltemperatur.

Ein derartiges Flüssigkeits-Kühlsystem ist in der DE 196 09 651 C2 in Verbindung mit einer Schaltschrank-Klimatisierungseinrichtung angegeben. Das Flüssigkeits-Kühlsystem ist dabei z.B. als Kühlgerät oder eine Kühleinheit mit Luft/Wasser-Wärmetauscher ausgebildet und stellt eine Komponente der gesamten Klimatisierungseinrichtung dar, die mittels einer übergeordneten Überwachungs- und Steuerungseinrichtung überwacht und gesteuert bzw. geregelt wird. Mit der Kühleinrichtung in Verbindung mit der Überwachungs- und Steuerungseinrichtung können je nach Einsatzfall bzw. Wunsch eines Anwenders vielfältige Steuerungskonzepte der Klimatisierung verwirklicht werden. Dabei ist auch die Möglichkeit gegeben, einzelne Elektronikbaugruppen lokal zu kühlen, wozu diesen zugeordnete Lüftereinheiten angesteuert werden. Ist ein Rack oder ein Schaltschrank mit einer Vielzahl von Elektronikbaugruppen hoher Rechnerleistung bestückt, können insbesondere im Bereich der Rechnereinheiten allerdings sehr hohe Wärmemengen anfallen, die auch mit einer derartigen Kühleinrichtung schwer zu beseitigen sind.

In der WO 97/34345 ist ein Schaltschranküberwachungs- und Steuerungssystem angegeben, in das u.a. auch eine Klimatisierungseinrichtung mit Kühlgerät und Lüftern sowie Wärmetauscher eingebunden ist. Ein Kühlkonzept zum Abführen von Wärme im Bereich einzelner Baugruppen ist in dieser Druckschrift nicht näher beschrieben.

In der DE 101 12 389 A ist eine andere Flüssigkeits - Kühleinrichtung für einen Schaltschrank offenbart.

Der Erfindung liegt die Aufgabe zugrunde, ein Flüssigkeits-Kühlsystem der ein-gangs genannten Art bereit zu stellen, mit dem insbesondere auch bei einer hohen Packungsdichte des Racks oder Schaltschranks mit Elektronikbaugruppen hoher Wärmeproduktion zuverlässig gekühlt werden und ein Wärmeschaden der Elektronikbaugruppen vermieden wird.

Diese Aufgabe wird mit den Merkmalen des Anspruches 1 gelöst. Hierbei ist vorgesehen, dass die Kühleinheiten als Flüssigkeits-Kühleinheiten ausgebildet und über Zweigstellen an ein in dem Rack oder Schaltschrank integriertes gemeinsames zentrales Flüssigkeitsleitungssystem angeschlossen sind und dass die Steuerungs-und Überwachungseinrichtung zum Überwachen der Kühltemperatur in dem zentralen Flüssigkeitsleitungssystem und Abgeben eines Fehlersignals bei Überschreitung einer vorgegebenen oder vorgebbaren Grenztemperatur in einem Flüssigkeitsrücklaufzweig oder Überschreitung einer vorgegebenen oder vorgebbaren Grenztemperaturdifferenz zwischen einer Temperatur in einem Vorlaufzweig und einer Temperatur in dem Rücklaufzweig oder bei Abfallen der Flüssigkeitsströmung unter einen vorgegebenen oder vorgebbaren Grenzwert ausgebildet ist.

Mit den Flüssigkeits-Kühleinheiten, die den Elektronikbaugruppen zugeordnet sind, werden diese mit hohem Wirkungsgrad zuverlässig gekühlt. Dabei wird eine übermäßige Erwärmung zuverlässig durch die Überwachung der Kühltemperatur und/ oder Strömung in dem zentralen Flüssigkeitsleitungssystem festgestellt und gegebenenfalls durch Abgabe eines entsprechenden Fehlersignals angezeigt bzw. im System durch entsprechende Verarbeitung berücksichtigt.

Eine Schädigung der zu kühlenden Elektronikbaugruppen wird dadurch sicher und mit einfachen Maßnahmen unterbunden, dass das Fehlersignal zum Auslösen eines Alarms und/oder zum Abschalten einer gemeinsamen Stromversorgung aller Elektronikbaugruppen genutzt ist.

Eine besonders wirkungsvolle Kühlung wird dadurch erzielt, dass die Kühleinheiten an temperaturempfindlichen wärmeproduzierenden elektronischen Bauelementen thermisch angekoppelte, von der Kühlflüssigkeit durchströmte Kühlelemente aufweisen.

Ein übersichtlicher Aufbau mit einfachen Anschlussmöglichkeiten wird dadurch erhalten, dass das zentrale Flüssigkeitsleitungssystem eine mit Vorlaufkanal und Rücklaufkanal versehene Leitungseinheit aufweist, die vertikal ausgerichtet in dem Rack oder Schaltschrank montiert ist und über ihre Länge zum Bilden der Zweigstellen mit vorzugsweise äquidistant angeordneten Koppelmitteln versehen ist.

Zu einem einfachen Aufbau mit leichten Montagemöglichkeiten tragen die Maßnahmen bei, dass ein in dem Rack oder Schaltschrank verlaufender Abschnitt des zentralen Flüssigkeitsleitungssystem an einem vertikalen Rahmenschenkel, an mindestens einer Montageschiene oder an der Innenseite eines Verkleidungsteils angebracht ist.

Dabei ergeben sich günstige Anordnungsmöglichkeiten dadurch, dass an oder in dem Rahmenschenkel eine vertikale, zum Innenraum des Racks oder Schaltschranks über ihre Länge offene Aufnahme integriert ist, in die der Abschnitt des zentralen Flüssigkeitsleitungssystems eingesetzt ist.

Verschiedene Ausgestaltungsvarianten für eine wirkungsvolle Kühlung bestehen darin, dass das zentrale Flüssigkeitsleitungssystem an einen Luft/Flüssigkeits-Wärmetauscher und/oder einen Flüssigkeits/Flüssigkeits-Wärmetauscher angeschlossen ist, und ferner darin, dass der Flüssigkeits/Flüssigkeits-Wärmetauscher an eine Rückkühlanlage angeschlossen ist.

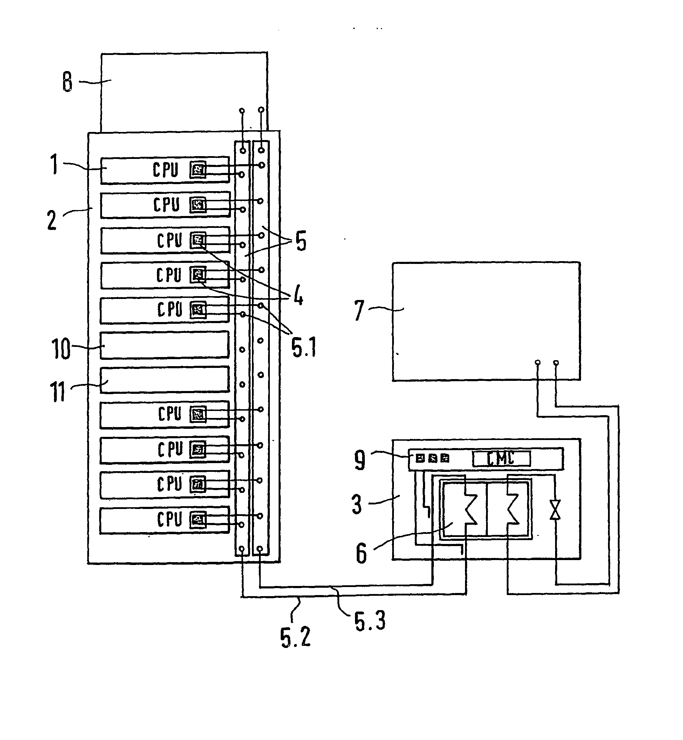

Die Erfindung wird nachfolgend anhand von Ausführungsbeispielen unter Bezugnahme auf die Zeichnung näher erläutert.

Die Fig. zeigt eine schematische Darstellung eines Aufbaubeispiels eines Flüssigkeits-Kühlsystems zum Kühlen einer Vielzahl von in einem Rack 2 aufgenommenen Elektronikbaugruppen 1, die jeweils als Haupt-Wärmeproduzenten mindestens eine zentrale Prozessoreinheit (CPU) 1.1 hoher Rechnerleistung in einem die Elektronikbaugruppe 1 beinhaltenden Gehäuse aufweisen.

Zum Kühlen der Elektronikbaugruppe 1, insbesondere der Prozessoreinheiten bzw. Rechnereinheiten 1.1, die als ein integriertes Bauelement ausgebildet sind, sind auf dem Bauelementkörper mit Kanälen versehene Kühlelemente 4 der Flüssigkeits-Kühleinheiten in engem wärmeleitendem Kontakt aufgebracht, durch die die Kühlflüssigkeit über einen möglichst langen Weg geleitet wird. Die Flüssigkeits-Kühleinheiten mit den Kühlelementen 4 sind über jeweilige Vorlauf-Zweigleitungen und Rücklauf-Zweigleitungen über entsprechende Zweigstellen 5.1 mit Koppelelementen an einen in dem Rack verlaufenden vertikalen Abschnitt eines zentralen Flüssigkeitsleitungssystems 5 angeschlossen. Das zentrale. Flüssigkeitsleitungssystem 5 weist ebenfalls einen Vorlaufzweig 5.2 und einen Rücklaufzweig 5.3 für die Kühlflüssigkeit auf, wobei der in dem Rack 2 bzw. Schaltschrank angeordnete vertikale Abschnitt vorzugsweise als eine Leitungseinheit 5.4 mit dem Vorlaufzweig 5.2 und dem Rücklaufzweig 5.3 ausgebildet ist.

Im unteren Bereich der Leitungseinheit 5.4 ist diese über einen weiteren Abschnitt des Vorlaufzweiges 5.2 und des Rücklaufzweiges 5.3 an einen in einem Elektronikgehäuse 3 aufgenommenen Wasser/Wasser-Wärmetauscher 6 angeschlossen. In dem Elektronikgehäuse 3 ist eine Überwachungs- und Steuerungseinrichtung 9 für Funktionen des Schaltschrankes oder Racks 2 aufgenommen, die u.a. auch an den Vorlaufzweig 5.2 und den Rücklaufzweig 5.3 angeschlossen ist, um die dort vorhandenen Temperaturen der Flüssigkeit bzw. des Wassers zu erfassen.

Zur Kühlung der Flüssigkeit ist/sind auch ein einfaches Rückkühlaggregat oder eine Lüftervorrichtung denkbar.

Über weitere Leitungen ist der Wasser/Wasser-Wärmetauscher 6 an eine Rückkühlanlage 7 angeschlossen, die eine zuverlässige Kühlung der Kühlflüssigkeit sicherstellt und die Möglichkeit bietet, die entstandene Wärme auch z.B. außerhalb des Raumes abzugeben, in dem sich das Rack 2 oder der Schaltschrank mit den zu kühlenden Elektronikbaugruppen befindet, um eine zu hohe Raumtemperatur zu vermeiden.

Zudem ist der obere Bereich des vertikalen Abschnittes des zentralen Flüssigkeitsleitungssystems 5 über weitere Leitungen an einen auf dem Rack 2 oder Schaltschrank angeordneten Luft/Wasser-Wärmetauscher 8 angeschlossen, mit dem eine weitere Kühlung der Flüssigkeit erreicht wird und zudem auch, bei entsprechender Ausgestaltung, die Allgemeintemperatur im Bereich der Baugruppen bzw. im Innenraum des Schaltschrankes herabgesetzt-werden kann.

Ferner sind in dem Rack 2 beispielhaft noch eine Monitor-Tastatur-Einheit 10 und eine Server-Schaltsteuerung (Server-Switch-Control) angeordnet, die aber wegen der geringeren Wärmeproduktion nicht an das zentrale Flüssigkeitsleitungssystem 5 angeschlossen sein müssen.

Stellt die Überwachungs- und Steuerungseinrichtung 9 z.B. mittels Temperaturfühler oder Flüsigkeitsströmungswächter in oder an dem Flüssigkeitsleitungssystem fest, dass z.B. die Absoluttemperatur im Rücklaufzweig 5.3 oder eine Temperaturdifferenz zwischen dem Vorlaufzweig 5.2 und dem Rücklaufzweig 5.3 eine vorgegebene oder vorgebbare Schwelle überschreitet, gibt sie ein Fehlersignal oder eine Fehlermeldung ab, mit dem z.B. eine Warnlampe oder ein Warnton eingeschaltet oder eine Anzeige zur Information eines Benutzers gesteuert werden können, wobei auch eine Weiterleitung über einen Netzwerkanschluss an eine entfernte Überwachungsstelle möglich ist. Eine vorteilhafte Maßnahme besteht auch darin, dass die Überwachungs- und Steuerungseinrichtung 9 so ausgebildet, dass sie bei Auftreten eines Fehlersignals eine gemeinsame Stromversorgung der in dem Rack 2 bzw. Schaltschrank befindlichen Elektronikbaugruppen 1 abschaltet, so dass sichergestellt ist, dass kein Temperaturschaden dieser in der Regel teuren Einrichtung eintritt. Auch eine weitergehende rechnerische Verarbeitung des Fehlersignals und/oder eine Speicherung in einer Fehlerspeichereinrichtung für eine Diagnose oder spätere Auswertung können vorgesehen sein. Die Überwachungs-und Steuerungseinrichtung 9 bildet dabei ein übergeordnetes Überwachungssystem, mit dem noch an-dere Sensorsignale aufgenommen und überwacht sowie verschiedene Aktoren auch des Kühlsystems gesteuert und geregelt werden können, wie in den ein-gangs genannten Druckschriften DE 196 09 651 C2 und WO 97/34345 näher ausgeführt.

Der in dem Rack 2 oder Schaltschrank angeordnete vertikale Abschnitt des zentralen Flüssigkeitsleitungssystems 5 ist vorzugsweise als Leitungseinheit mit einem Vorlaufkanal und einem Rücklaufkanal ausgebildet und kann separat in dem Innenraum des Racks 2 bzw. Schaltschranks z.B. an einem vertikalen Rahmenschenkel, Montageschienen oder der Innenseites eines Verkleidungsteils angebracht sein. Vorteilhaft ist insbesondere auch eine Ausgestaltung, bei der ein vertikaler Rahmenschenkel eine zum Innenraum des Racks 2 bzw. Schaltschranks über ihre Länge offene, im Querschnitt z.B. U-förmige Aufnahme besitzt, in die die Leitungseinheit auch nachträglich eingesetzt und darin fixiert, z.B. verrastet werden kann. Über die Länge der Leitungseinheit 5.4 sind in regelmäßigen Abständen Anschlussstellen mit Koppelelementen zum Anschließen der zu den Elektronikbaugruppen 1 führenden Zweigleitungen ausgebildet.

## Patentansprüche

1. Flüssigkeits-Kühlsystem mit mehreren in einem Rack (2) oder Schaltschrank untergebrachten und jeweiligen zu kühlenden Elektronikbaugruppen (1) individuell zugeordneten Kühleinheiten (4) und ferner mit einer Überwachungs-und Steuerungseinrichtung (9) zum Überwachen der Kühltemperatur, wobei die Kühleinheiten (4) als Flüssigkeits-Kühleinheiten ausgebildet und über Zweigstellen (5.1) an ein in dem Rack (2) oder Schaltschrank integriertes gemeinsames zentrales Flüssigkeitsleitungssystem (5) angeschlossen sind
**dadurch gekennzeichnet, dass** die Steuerungs- und Überwachungseinrichtung zum Überwachen der Kühltemperatur in dem zentralen Flüssigkeitsleitungssystem (5) und Abgeben eines Fehlersignals bei Überschreitung einer vorgegebenen oder vorgebbaren Grenztemperatur in einem Flüssigkeitsrücklaufzweig (5.3) oder Überschreitung einer vorgegebenen oder vorgebbaren Grenztemperaturdifferenz zwischen einer Temperatur in einem Vorlaufzweig (5.2) und einer Temperatur in dem Rücklaufzweig (5.3) oder bei Abfallen der Flüssigkeitsströmung unter einem vorgegebenen oder vorgebbaren Grenzwert ausgebildet ist.

2. Kühlsystem nach Anspruch 1,
**dadurch gekennzeichnet,**
**dass** das Fehlersignal zum Auslösen eines Alarms und/oder zum Abschalten einer gemeinsamen Stromversorgung aller Elektronikbaugruppen (1) genutzt ist.

3. Kühlsystem nach Anspruch 1 oder 2,
**dadurch gekennzeichnet,**
**dass** die Kühleinheiten (4) an temperaturempfindlichen wärmeproduzierenden elektronischen Bauelementen thermisch angekoppelte, von der Kühlflüssigkeit durchströmte Kühlelemente aufweisen.

4. Kühlsystem nach einem der vorhergehenden Ansprüche,
**dadurch gekennzeichnet,**
**dass** das zentrale Flüssigkeitsleitungssystem (5) eine mit Vorlaufkanal und Rücklaufkanal versehene Leitungseinheit (5.4) aufweist, die vertikal ausgerichtet in dem Rack (2) oder Schaltschrank montiert ist und über ihre Länge zum Bilden der Zweigstellen (5.1) mit äquidistant angeordneten Koppelmitteln versehen ist.

5. Kühlsystem nach einem der vorhergehenden Ansprüche,
**dadurch gekennzeichnet,**
**dass** ein in dem Rack (2) oder Schaltschrank verlaufender Abschnitt des zentralen Flüssigkeitsleitungssystem (5) an einem vertikalen Rahmenschenkel, an mindestens einer Montageschiene oder an der Innenseite eines Verkleidungsteils angebracht ist.

6. Kühlsystem nach Anspruch 5,
**dadurch gekennzeichnet,**
**dass** an oder in dem Rahmenschenkel eine vertikale, zum Innenraum des Rackes (2) oder Schaltschranks über ihre Länge offene Aufnahme integriert ist, in die der Abschnitt des zentralen Flüssigkeitsleitungssystems (5) eingesetzt ist.

7. Kühlsystem nach einem der vorhergehenden Ansprüche,
**dadurch gekennzeichnet,**
**dass** das zentrale Flüssigkeitsleitungssystem (5) an einen Luft/Flüssigkeits-Wärmetauscher (8) und/oder einen Flüssigkeits/Flüssigkeits-Wärmetauscher (6) angeschlossen ist.

8. Kühlsystem nach Anspruch 7,
**dadurch gekennzeichnet,**
**dass** der Flüssigkeits/Flüssigkeits-Wärmetauscher (6) an eine Rückkühlanlage (7) angeschlossen ist.

## Claims

1. Liquid cooling system, having a plurality of cooling units (4), which are accommodated in a rack (2) or switchgear cabinet and are each individually associated with respective electronic cooling assemblies (1) to be cooled, and furthermore having a monitoring and controlling means (9) for monitoring the cooling temperature, the cooling units (4) being in the form of liquid cooling units and being connected, via branch points (5.1), to a common central liquid conduction system (5) incorporated in the rack (2) or switchgear cabinet, **characterised in that** the controlling and monitoring means is designed to monitor the cooling temperature in the central liquid conduction system (5) and to emit an error signal when a prescribed or prescribable limit temperature is exceeded in a liquid back-flow branch (5.3), or when a prescribed or prescribable limit temperature difference between a temperature in a forward-flow branch (5.2) and a temperature in the back-flow branch (5.3) is exceeded, or when the liquid flow falls below a prescribed or prescribable limit value.

2. Cooling system according to claim 1, **characterised in that** the error signal is used to trigger an alarm and/or to switch-off a common current forward-flow to all of the electronic assemblies (1).

3. Cooling system according to claim 1 or 2, **characterised in that** the cooling units (4) have cooling elements which are thermally connected to temperature-sensitive heat-producing electronic components and which are traversed by the cooling liquid.

4. Cooling system according to one of the preceding claims, **characterised in that** the central liquid conduction system (5) includes a conduction unit (5.4) provided with a forward-flow duct and a back-flow duct, which conduction unit is mounted in a vertically orientated manner in the rack (2) or switchgear cabinet, and is provided with equidistantly disposed coupling means over its length to form the branch points (5.1).

5. Cooling system according to one of the preceding claims, **characterised in that** a portion of the central liquid conduction system (5), extending in the rack (2) or switchgear cabinet, is attached to a vertical frame member, to at least one assembly rail or to the inside of a cladding part.

6. Cooling system according to claim 5, **characterised in that** a vertical receiver is incorporated on or in the frame member, which receiver is open to the interior of the rack (2) or switchgear cabinet over its length, and into which receiver is inserted the portion of the central liquid conduction system (5).

7. Cooling system according to one of the preceding claims, **characterised in that** the central liquid conduction system (5) is connected to an air/liquid heat exchanger (8) and/or to a liquid/liquid heat exchanger (6).

8. Cooling system according to claim 7, **characterised in that** the liquid/liquid heat exchanger (6) is connected to a back-flow cooling system (7).

## Revendications

1. Système de refroidissement à fluide avec plusieurs unités de refroidissement (4) logées dans un rack (2) ou une armoire de commande et individuellement associées à des modules électroniques (1) respectifs à refroidir ainsi qu'avec un dispositif de surveillance et de commande (9) pour surveiller la température de refroidissement,
les unités de refroidissement (4) étant conçues comme unités de refroidissement à fluide et raccordées par l'intermédiaire de points de branchement (5.1) à un système central de conduites de fluide (5) commun intégré dans le rack (2) ou l'armoire de commande,
**caractérisé en ce**
**que** le dispositif de commande et de surveillance (9) est conçu pour surveiller la température de refroidissement dans le système central de conduites de fluide (5) et émettre un signal d'erreur en cas de dépassement d'une température limite prescrite ou prescriptible dans une branche de retour ou d'extraction de fluide (5.3) ou de dépassement d'une différence de température limite prescrite ou prescriptible entre une température dans une branche de départ ou d'injection (5.2) et une température dans la branche de retour ou d'extraction (5.3) ou en cas de chute du courant de fluide au-dessous d'une valeur limite prescrite ou prescriptible.

2. Système de refroidissement selon la revendication 1,
**caractérisé en ce**
**que** le signal d'erreur est utilisé pour déclencher une alarme et/ou pour couper une alimentation électrique commune à tous les modules électroniques (1).

3. Système de refroidissement selon la revendication 1 ou 2,
**caractérisé en ce**
**que** les unités de refroidissement (4) présentent des éléments de refroidissement traversés par le fluide de refroidissement, couplés thermiquement à des composants électroniques produisant de la chaleur et sensibles à la température.

4. Système de refroidissement selon l'une des revendications précédentes,
**caractérisé en ce**
**que** le système central de conduites de fluide (5) présente une unité de conduites (5.4) pourvue d'un canal de départ et d'un canal de retour, qui est montée en orientation verticale dans le rack (2) ou l'armoire de commande et pourvue sur sa longueur de moyens de couplage disposés de manière équidistante pour former les points de branchement (5.1).

5. Système de refroidissement selon l'une des revendications précédentes,
**caractérisé en ce**
**qu'**une portion du système central de conduites de fluide (5) s'étendant dans le rack (2) ou l'armoire de commande est appliquée sur un élément de cadre vertical, sur au moins un rail de montage ou sur le côté intérieur d'une pièce d'habillage.

6. Système de refroidissement selon la revendication 5,
**caractérisé en ce**
**qu'**un logement vertical, ouvert sur sa longueur vers l'intérieur du rack (2) ou de l'armoire de commande, dans lequel la portion du système central de conduites de fluide (5) est insérée, est intégré sur ou dans l'élément de cadre.

7. Système de refroidissement selon l'une des revendications précédentes,
**caractérisé en ce**
**que** le système central de conduites de fluide (5) est raccordé à un échangeur thermique air/fluide (8) et/ou à un échangeur thermique fluide/fluide (6).

8. Système de refroidissement selon la revendication 7,
**caractérisé en ce**
**que** l'échangeur thermique fluide/fluide (6) est raccordé à une installation de refroidissement à circulation (7).
